(19) Europäisches Patentamt
European Patent Office
Office européen des brevets

(11) **EP 4 550 401 A1**

(12) **EUROPEAN PATENT APPLICATION**
published in accordance with Art. 153(4) EPC

(43) Date of publication:
**07.05.2025 Bulletin 2025/19**

(21) Application number: **23831589.9**

(22) Date of filing: **29.06.2023**

(51) International Patent Classification (IPC):
**H01L 23/13** (2006.01)    **H01L 23/15** (2006.01)

(52) Cooperative Patent Classification (CPC):
**H01L 24/32; H01L 23/13; H01L 23/49822;**
H01L 23/15; H01L 24/29; H01L 2224/29139;
H01L 2224/29147; H01L 2224/32225

(86) International application number:
**PCT/JP2023/024213**

(87) International publication number:
**WO 2024/005150 (04.01.2024 Gazette 2024/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.06.2022  JP 2022104850**

(71) Applicants:
• **Kabushiki Kaisha Toshiba**
  **Tokyo 105-0023 (JP)**

• **Toshiba Materials Co., Ltd.**
  **Isogo-Ku**
  **Yokohama-Shi**
  **Kanagawa 235-0032 (JP)**

(72) Inventor: **HONDA, Yasuhiro**
  **Yokohama-shi, Kanagawa 235-0032 (JP)**

(74) Representative: **Henkel & Partner mbB**
  **Patentanwaltskanzlei, Rechtsanwaltskanzlei**
  **Maximiliansplatz 21**
  **80333 München (DE)**

(54) **CERAMIC COPPER CIRCUIT BOARD AND SEMICONDUCTOR DEVICE USING SAME**

(57)    Provided are: a ceramic copper circuit board in which the average length RSm of the roughness curve element on the surface of a copper member is controlled; and a semiconductor device using same. A ceramic copper circuit to one surface of the ceramic substrate. When the average length RSm of the roughness curve element is measured at each of five arbitrary points selected from the surface of the copper member, the average value of the five average lengths RSm is 40-250μm

FIG. 3

EP 4 550 401 A1

**Description**

[Technical Field]

Embodiments described below relate generally to a ceramic copper circuit board and a semiconductor device using a ceramic copper circuit board.

[Background Art]

A ceramic copper circuit board in which a ceramic substrate and a copper plate are bonded is used as a circuit board to which a semiconductor element or the like is mounted. Also, junction temperatures are expected to increase as the performance of semiconductor elements increases. Accordingly, bonding that uses Ag nanoparticles is being investigated for mounting semiconductor elements. To perform bonding using Ag nanoparticles, the formation of a Ag layer on the metal plate surface is being investigated. For example, a ceramic circuit board described in Japanese Patent No. 6262968 (Patent Literature 1) is a ceramic circuit board in which the surface roughness (the arithmetic average roughness Ra) of a circuit board in which a ceramic substrate and an aluminum plate are bonded via a bonding layer is improved. Also, Ag paste is used to mount semiconductor elements and the like. A plating film is formed on the copper plate surface to improve adhesion with the silver layer. The plating film includes a Ni-P plating film. For example, JP-A 2019-41108 (Kokai) (Patent Literature 2) illustrates a recess provided in the copper surface.

[Prior Art Documents]

[Patent Literature]

Patent Literature 1: Japanese Patent No. 6262968
Patent Literature 2: JP-A 2019-41108 (Kokai)

[Summary of Invention]

[Problem to be Solved by the Invention]

As described above, silver (Ag) paste has been used to improve bondability with a semiconductor element. On the other hand, a phenomenon of reduced bonding strength occurred when a silver (Ag) layer was located on the copper member of the ceramic copper circuit board. The cause was investigated to determine the cause to be the average length RSm of the roughness curve elements of the surface of the copper member. The invention is directed to address such problems, and to provide a ceramic copper circuit board in which the average length RSm of the roughness curve elements of the surface of the copper member is controlled.

[Means for Solving the Problem]

A ceramic copper circuit board according to an embodiment includes a ceramic substrate, and a copper member bonded to one surface of the ceramic substrate. An average value of five average lengths RSm is not less than 40 $\mu$m and not more than 250 $\mu$m; and the five average lengths RSm are average lengths RSm of roughness curve elements measured respectively at any five locations selected from a surface of the copper member.

[Brief Description of Drawings]

[FIG. 1]

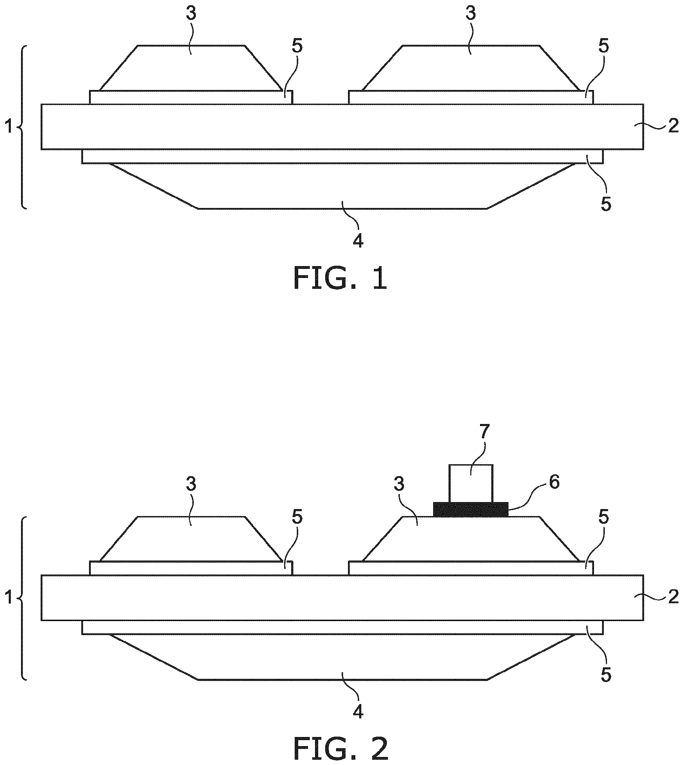

FIG. 1 is a schematic view showing an example of a ceramic copper circuit board according to an embodiment.
[FIG. 2]
FIG. 2 is a schematic view showing a method of a bonding strength (peel strength) test of an example.
[FIG. 3]

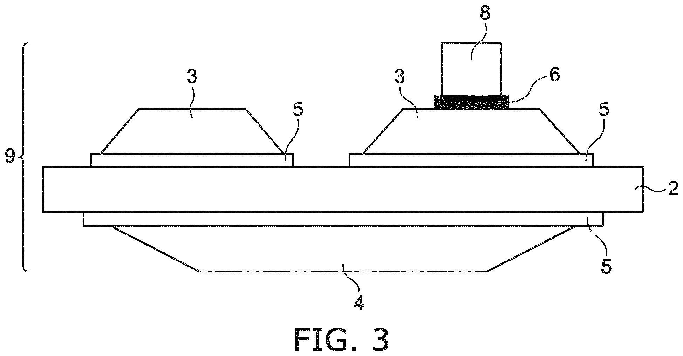

FIG. 3 is a schematic view showing an example of a semiconductor device according to an embodiment.

[Detailed Description]

A ceramic copper circuit board according to an embodiment includes a ceramic substrate, and a copper member bonded to one surface of the ceramic substrate. An average value of five average lengths RSm is not less than 40 μm and not more than 250 μm; and the five average lengths RSm are average lengths RSm of roughness curve elements measured respectively at any five locations selected from a surface of the copper member.

Drawings of the application will now be described. FIG. 1 is a schematic view showing an example of a ceramic copper circuit board according to an embodiment of the invention. FIG. 1 shows an example in which two copper plates are bonded to two surfaces of a ceramic substrate. The copper plates are examples of copper members. In FIG. 1, 1 is a ceramic copper circuit board, 2 is a ceramic substrate, 3 is a copper plate (a front copper plate), 4 is a copper plate (a back copper plate), and 5 is a brazing material layer (an active metal brazing material layer).

In the ceramic copper circuit board 1 shown in FIG. 1, the copper plate 3 and the copper plate 4 are disposed respectively at two surfaces of the ceramic substrate 2 with the brazing material layers 5 interposed. In the structure shown in FIG. 1, the copper plate 3 is provided with a circuit configuration; and the copper plate 4 is used as a heat dissipation plate. For convenience, the copper plate 3 is called the front copper plate; and the copper plate 4 is called the back copper plate. Also, two front copper plates 3 are provided. The ceramic copper circuit board 1 according to the embodiment is not limited to such a configuration. Three or more front copper plates 3 may be located at the ceramic substrate 2, or only one front copper plate 3 may be located at the ceramic substrate 2. Also, the ceramic copper circuit board 1 may have a structure in which the back copper plate 4 is provided with a circuit configuration. Or, the ceramic copper circuit board 1 may have a structure in which only the front copper plate 3 is included without including the back copper plate 4. FIG. 1 shows an example in which copper plates are bonded to two surfaces of the ceramic substrate 2. When the back copper plate 4 is used as a heat dissipation member, an aluminum plate may be used as the heat dissipation plate instead of the back copper plate 4.

FIG. 2 is a schematic view showing a method of a bonding strength (peel strength) test of an example of the invention. In FIG. 2, 1 is a ceramic copper circuit board, 6 is a bonding layer, and 7 is a silver ribbon. As shown in FIG. 2, the peel strength test is performed using a silver ribbon. FIG. 3 is a schematic view showing an example of a semiconductor device according to an embodiment of the invention. In FIG. 3, 6 is a bonding layer, 8 is a semiconductor element, and 9 is a semiconductor device. In the semiconductor device 9 shown in FIG. 3, one semiconductor element 8 is mounted to the front copper plate 3. The semiconductor device 9 may include multiple semiconductor elements 8. Multiple semiconductor elements 8 may be mounted to one front copper plate 3. Also, although the semiconductor device 9 includes the bonding layer 6 (the brazing material layer) in the example shown in FIG. 3, the bonding layer 6 may not be included, and the front copper plate 3 and the semiconductor element 8 may be directly bonded.

The ceramic substrate 2 is a silicon nitride substrate, an aluminum nitride substrate, an aluminum oxide substrate, an Alusil substrate, etc. It is favorable for the thickness of the ceramic substrate 2 to be not less than 0.1 mm and not more than 3 mm. When the thickness of the substrate is less than 0.1 mm, there is a possibility that the strength may decrease. When the thickness of the substrate is greater than 3 mm, there is a possibility that the ceramic substrate 2 may become a thermal resistor, and the heat dissipation of the ceramic copper circuit board 1 may degrade. A more favorable range of the thickness of the ceramic substrate 2 is not less than 0.2 mm and not more than 2 mm.

It is favorable for the three-point bending strength of the silicon nitride substrate to be not less than 600 MPa. It is favorable for the thermal conductivity to be not less than 80 W/m·K. As long as the thermal conductivity is not less than 80 W/m·K, the thermal conductivity of the silicon nitride substrate may be not less than 90 W/m·K or not less than 130 W/m·K. By increasing the strength of the substrate, the substrate thickness can be reduced. It is therefore favorable for the three-point bending strength of the silicon nitride substrate to be not less than 600 MPa, and more favorably not less than 700 MPa. By using the silicon nitride substrate, the substrate thickness can be thin and can be not more than 0.40 mm, or even not more than 0.30 mm.

The three-point bending strength of an aluminum nitride substrate is about 300 to 450 MPa. On the other hand, the thermal conductivity of an aluminum nitride substrate is not less than 160 W/m·K. Because the strength of the aluminum nitride substrate is low, it is favorable for the substrate thickness to be not less than 0.60 mm. Although the three-point bending strength of an aluminum oxide substrate is about 300 to 450 MPa, an aluminum oxide substrate is inexpensive. Although the three-point bending strength of an Alusil substrate high and is about 550 MPa, the thermal conductivity is about 30 to 50 W/m·K. An Alusil substrate is a substrate made of a sintered body in which aluminum oxide and zirconium oxide are mixed.

It is favorable for the ceramic substrate 2 to be one of a silicon nitride substrate or an aluminum nitride substrate. The silicon nitride substrate and the aluminum nitride substrate are nitride ceramic substrates. A nitride ceramic forms titanium nitride by reacting with an active metal brazing material including Ti. An oxide ceramic forms titanium oxide by reacting with an active metal brazing material including Ti. By using active metal bonding, the nitride ceramic can increase the bonding strength with the copper member (particularly a copper plate).

The copper member is oxygen-free copper, a copper alloy, etc. Generally, the thermal conductivity of copper is high and is about 400 W/m·K, and so the heat dissipation of the ceramic copper circuit board 1 can be improved. Also, the thickness of the copper plate 3 and the thickness of the copper plate 4 may be not less than 0.3 mm, or even not less than 0.6 mm. A copper plate that is not less than 0.6 mm includes, for example, a 1 mm copper plate, a 2 mm copper plate, etc.

By making the copper plate thick, the heat dissipation of the bonded body (the ceramic copper circuit board 1) can be improved. Also, the thickness of the front copper plate 3 and the thickness of the back copper plate 4 may be the same or may be different from each other. It is favorable for the copper member to be a member made of oxygen-free copper or a member in which a graphite layer is present inside a copper layer. Oxygen-free copper has a copper purity of not less than 99.96 wt% as defined in JIS-H-3100 (ISO 1337, etc.). The copper member may be directly bonded to the ceramic substrate 2, or may be bonded to the ceramic substrate 2 via a brazing material layer. A copper member that is provided with a circuit configuration beforehand by stamping a copper plate, etc., may be bonded to the ceramic substrate. The copper plate may be provided with a circuit configuration by etching after the copper plate is bonded to the ceramic substrate. The heat dissipation member may have a jutting shape with respect to the ceramic substrate (e.g., the heat dissipation plate and the leadframe have a shape that is formed as one piece). A groove shape may be provided in the heat dissipation member.

In the ceramic copper circuit board 1 according to the embodiment, it is favorable for the average value of five average lengths RSm to be not less than 40 $\mu$m and not more than 250 $\mu$m, wherein the five average lengths RSm are average lengths RSm of roughness curve elements measured respectively at any five locations selected from the surface of the copper member. More favorably, the average value of the five average lengths RSm is not less than 50 $\mu$m and not more than 200 $\mu$m. Most favorably, the average value of the five average lengths RSm is not less than 60 $\mu$m and not more than 150 $\mu$m. When the average length RSm of the roughness curve elements is within the ranges described above, it is easy for the bonding material to properly penetrate micro recesses in the surface of the copper plate 4. Therefore, the bonding between the copper plate 4 and the bonding layer 6 can be more secure.

The five arbitrary locations are selected from regions that do not overlap each other and are separated from each other by not less than 500 $\mu$m. Also, "surface" refers to a region other than a side surface. The average length RSm of the roughness curve elements at the side surface may be within the favorable ranges described above, or may be outside the ranges.

The measurement length for one measurement is set to 4 mm. When a measurement length having a value of 4 mm cannot be measured, a measurement of multiple locations (not more than three locations) is performed instead. Each measurement length is set so that the total value of the measurement lengths of the multiple locations is 4 mm; and the average lengths RSm measured at each location are averaged according to the ratios of the measurement lengths.

For example, the RSm value measured for a measurement length of 3 mm at a first location is $A$ $\mu$m; and the RSm value measured for a measurement length of 1 mm at a second location is $B$ $\mu$m. In such a case, RSm is calculated by the following formula.

$$RSm = (3A + B)/4$$

JIS B 0601:2013 is referenced to calculate surface roughnesses such as the average length RSm, etc. JIS-B-0601 corresponds to ISO 4287. To measure the surface roughness, a device that has about the same measurement accuracy or a better measurement accuracy than SURFCOM 2000 DX-23 made by Tokyo Seimitsu Co., Ltd. is used.

It is favorable for the minimum value of the five average lengths RSm to be not less than 30 $\mu$m. Accordingly, it is more favorable for each numerical value (the absolute value) of the five average lengths RSm to be not less than 30 $\mu$m and not more than 250 $\mu$m. More favorably, each numerical value of the five average lengths RSm is not less than 35 $\mu$m and not more than 150 $\mu$m. Most favorably, each numerical value of the five average lengths RSm is not less than 40 $\mu$m and not more than 140 $\mu$m. The individual average length RSm values being within the ranges described above means that the average length RSm difference between the measurement locations is small, and the fluctuation is controlled. Accordingly, the fluctuation of the bonding strength can be reduced, and the ceramic copper circuit board 1 that is easier to use is obtained.

Also, it is favorable to control the arithmetic average roughness Ra in addition to the average length RSm. It is favorable for the average value of five arithmetic average roughnesses Ra to be not less than 0.1 $\mu$m and not more than 0.7 $\mu$m, wherein the five arithmetic average roughnesses Ra are arithmetic average roughnesses Ra measured respectively at any five locations selected from the surface of the copper member. More favorably, the average value of the five arithmetic average roughnesses Ra is not less than 0.2 $\mu$m and not more than 0.6 $\mu$m. Also, it is favorable for each of the five arithmetic average roughnesses Ra to be greater than 0 $\mu$m and not more than 1.5 $\mu$m. More favorably, one of the arithmetic average roughnesses Ra also is not less than 0.05 $\mu$m and not more than 1.0 $\mu$m.

It is also favorable to control the maximum valley depth Rv of the roughness curve. It is favorable for the average value of five maximum valley depths Rv to be not less than 0.4 $\mu$m and not more than 2.5 $\mu$m, wherein the five maximum valley depths Rv are maximum valley depths Rv of roughness curves measured respectively at any five locations selected from the surface of the copper member. More favorably, the average value of the five maximum valley depths Rv is not less

than 0.5 μm and not more than 2.0 μm. More favorably, the average value of the five maximum valley depths Rv is not less than 0.6 μm and not more than 1.8 μm.

It is favorable to control the surface roughness so that the minimum value of the five maximum valley depths Rv is not less than 0.25 μm and not more than 2.5 μm. It is more favorable to control the surface roughness so that the minimum value of the five maximum valley depths Rv is not less than 0.3 μm and not more than 2.4 μm. It is more favorable to control the surface roughness so that the minimum value of the five maximum valley depths Rv is not less than 0.4 μm and not more than 2.3 μm.

Also, it is favorable to control the maximum height roughness Rz as well. It is favorable for the average value of five maximum height roughnesses Rz to be not more than 10 μm, wherein the five maximum height roughnesses Rz are maximum height roughnesses Rz of roughness curves measured respectively at any five locations selected from the surface of the copper member.

When the average length RSm, the arithmetic average roughness Ra, the maximum valley depth Rv, and the maximum height roughness Rz are measured, the measurement locations all are the same locations. That is, the five locations at which the average length RSm is measured, the five locations at which the arithmetic average roughness Ra is measured, the five locations at which the maximum valley depth Rv is measured, and the five locations at which the maximum height roughness Rz is measured are respectively the same.

In the ceramic copper circuit board 1, it is favorable for the ceramic substrate 2 and the copper plate 3 to be bonded via the brazing material layer 5. Also, it is favorable for the brazing material layer 5 to include silver (Ag), copper (Cu), or an active metal. Specific examples include a brazing material layer that includes Ag, Cu, and an active metal, a brazing material layer that includes copper and an active metal but substantially does not include Ag, a brazing material layer that includes Cu and magnesium (Mg), etc. Substantially not including Ag means that Ag is not added intentionally and Ag, if any, is included unavoidably as an impurity. Sn or In may be added as necessary. The brazing material layer 5 may include not less than 0.1 mass% and not more than 10 mass% of at least one selected from carbon (C), tungsten (W), molybdenum (Mo), and rhenium (Re). By adding carbon, tungsten, molybdenum, and rhenium, the fluidity of the active metal brazing material can be controlled. Also, manganese (Mn) may be added to the brazing material layer 5 as necessary.

It is favorable to use an active metal brazing material that includes an active metal to bond between the ceramic substrate 2 and the copper plate 4. It is favorable for the active metal to be at least one selected from Ti (titanium), Nb (niobium), Zr (zirconium), and Hf (hafnium). It is favorable for the active metal brazing material to include at least Ti. Also, it is favorable for the thickness of the bonding layer to be not less than 5 μm. More favorably, the thickness of the brazing material layer 5 is not less than 10 μm and not more than 200 μm. More favorably, the thickness of the brazing material layer 5 is not less than 15 μm and not more than 150 μm. When the brazing material layer 5 is thin, i.e., less than 5 μm, there is a possibility that a sufficient bonding strength cannot be maintained. On the other hand, when the brazing material layer 5 is thick, i.e., greater than 200 μm, there is a possibility that a cost increase may result.

Compositions of the brazing material components and the bonding method will now be described. It is favorable for the Ag content included in the brazing material to be within the range of not less than 0 mass% and not more than 95 mass%. It is favorable for the Cu content to be within the range of not less than 3 mass% and not more than 90 mass%. It is favorable for the total content of the active metal or the active metal hydride to be within the range of not less than 1 mass% and not more than 15 mass%. It is favorable for the total content of Sn or In to be within the range of not less than 1 mass% and not more than 30 mass%. More favorably, the total content of Sn or In is within the range of not less than 2 mass% and not more than 15 mass%.

Ag or Cu is a component used as a major component of the brazing material layer 5. The active metal or the active metal hydride is a component that reacts with the ceramic substrate 2 to obtain secure bonding. Sn or In has the effect of lowering the melting point of the active metal brazing material. The brazing material may include other unavoidable impurities.

Not less than 0.1 mass% and not more than 2 mass% of carbon (C) may be added to the active metal brazing material. Also, not less than 0.1 mass% and not more than 10 mass% of at least one selected from tungsten (W), molybdenum (Mo), and rhenium (Re) may be added to the active metal brazing material. By adding carbon, tungsten, molybdenum, and rhenium, the fluidity of the active metal brazing material can be controlled. Manganese (Mn) may be added to the brazing material as necessary.

The component ratios of the active metal brazing material described above are the ratios when the total of the metal components is taken to be 100 mass%. For example, when a titanium nitride powder is used, the mass% of titanium is used. The mass of organic substances such as the binder, etc., is not counted. In the bonding method according to the embodiment, a brazing material paste having the composition described above may be made and coated onto the ceramic substrate; or, instead of a brazing material paste, a metal foil having the composition described above may be used. Here, a method in which a brazing material paste is used will be described. The active metal brazing material paste is prepared by mixing the brazing material components and adding a binder, etc.

The ceramic substrate 2 is applicable to various substrates. Examples of the ceramic substrate include a silicon nitride substrate, an aluminum nitride substrate, an alumina substrate, a zirconium substrate, and an Alusil (a mixture of alumina and zirconia) substrate. The types of substrates also can be classified into an oxide ceramic substrate or a nitride ceramic substrate. The types of substrates also can be classified according to the metal component such as a silicon-including ceramic substrate, an aluminum-including ceramic substrate, and a zirconium-including ceramic.

Silicon nitride substrates and aluminum nitride substrates are called nitride ceramic substrates. When a nitride ceramic and a copper plate are bonded by active metal bonding, an active metal nitride layer is formed by reacting an active metal and a nitride ceramic substrate. A titanium nitride (TiN) layer is formed when Ti is used as the active metal. By forming the active metal nitride layer, the bonding strength between the ceramic substrate 2 and the copper plate 3 can be increased.

Aluminum oxide substrates, zirconium oxide substrates, and Alusil substrates are called oxide ceramic substrates. When an oxide ceramic substrate and a copper plate are bonded by active metal bonding, an active metal oxide layer is formed by reacting the active metal and the oxide ceramic substrate. When Ti is used as the active metal, a titanium oxide ($TiO_2$) layer is formed. By forming such an active metal oxide layer, the bonding strength between the ceramic substrate 2 and the copper plate 3 can be increased.

The bonded body in which the ceramic substrate 2 and the copper plate 3 are bonded may be a collective substrate for multipart manufacturing that is subdivided into two or more. Individual bonded bodies are obtained by subdividing the collective substrate into a plurality. The bonded body also may include a notched shape or a through-hole for fastening by screwing, etc. That is, the shape of the ceramic copper circuit board 1 is not limited to a rectangular shape such as that shown in the drawing. Also, it is favorable to obtain the ceramic copper circuit board 1 such as that of FIG. 1 by mounting the copper plates to the two surfaces of the ceramic substrate and heating at 850 °C, and by patterning the front copper plate by etching after the bonded body is made.

It is favorable for the thickness of the copper member to be not less than 0.3 mm. By making the copper plate 3 thick, the heat dissipation can be improved. Also, the current-carrying capacity can be increased. It is therefore favorable for the thickness of the copper plate to be not less than 0.3 mm, and more favorably not less than 0.6 mm. Although the upper limit of the thickness of the copper plate is not particularly limited, it is favorable for the upper limit to be not more than 5 mm. When greater than 5 mm, there is a possibility that it may be difficult to provide the circuit configuration by etching. It is favorable for both the thickness of the front copper plate 3 and the thickness of the back copper plate 4 to be not less than 0.3 mm.

Here, "copper plate" also includes a copper alloy plate. It is favorable for the copper plate to be an oxygen-free copper plate. Oxygen-free copper has a copper purity of not less than 99.96 wt% as defined in JIS-H-3100. A coating may be provided at the surface of the copper member; and a corrosion inhibitor may be coated. The corrosion inhibitor and the coating may be partially provided, or may be provided over the entire surface of the copper member. The copper plate may be provided with a prescribed configuration such as a circuit configuration, etc., before bonding by stamping, etc. Also, a corrosion inhibitor may be coated onto the copper plate surface.

FIG. 1 shows an example in which the ceramic copper circuit board 1 has a three-layer structure of copper-ceramic-copper. The structure of the ceramic copper circuit board 1 is not limited to the illustrated example. For example, the ceramic copper circuit board 1 may have a structure of five or more layers such as copper-ceramic-copper-ceramic-copper.

It is favorable to use a paste including at least one selected from silver and copper to bond between the copper plate and the semiconductor element. More favorably, at least one of silver or copper is used as a major component among the solid components. Here, "major component" refers to a component accounting for not less than 50 wt%. A bonding material that includes not less than 50 wt% silver or copper is discriminated from general SnAg solder or SnCu solder. It is favorable for the paste used to bond the semiconductor element not to include more than an impurity amount of metal components other than copper or silver. More favorably, silver paste or copper paste is used. More favorably, silver paste is used. Although there is a possibility that ion migration may occur, silver paste oxidizes less easily than copper. This is favorable because the bonding reliability can be maintained. Although copper paste oxidizes easily, ion migration does not occur easily. Accordingly, the paste may be selectively used according to the application of the ceramic copper circuit board 1.

Here, although a structure of copper member-ceramic substrate-copper member is described as an example according to the embodiment of the invention, the structure of the ceramic copper circuit board 1 is not particularly limited. The ceramic copper circuit board 1 may have a structure such as copper member-ceramic substrate-copper member-ceramic substrate-copper member. The heat dissipation plate may be aluminum such as that of copper member-ceramic substrate-aluminum member. The thickness of the heat dissipation plate may be different from the thickness of the circuit part (the front copper plate 3). The heat dissipation plate may have a one-piece shape with a lead. In other words, the copper member may jut with respect to the ceramic substrate 2.

Methods for controlling the surface roughness will now be described. First, the ceramic copper circuit board 1 is prepared. Then, the surface roughness of the copper member (the front copper plate 3) is measured, and it is checked whether or not the surface roughness is within a favorable range. In a general copper member, it is often that the surface is smooth, and the average value of the average lengths RSm is less than 40 μm. In the process of preparing the ceramic copper circuit board 1, the surface roughness may be controlled by a method other than the methods illustrated below. For example, the surface roughness may be controlled to be within a favorable range by adapting the bonding process of the removal process of the resist provided on the surface of the copper member. When the surface roughness is not in a favorable range, it is favorable to perform a process of controlling the surface properties. A surface property control process may be performed without measuring the surface properties. Examples of the method for controlling the surface properties include abrasive paper, plasma processing, etc.

Examples of abrasive paper include sandpaper, etc. When sandpaper is used, it is favorable for the grain size (the particle size) to be not less than 20 μm and not more than 50 μm. The surface roughness may be adjusted not only by controlling the grain size, but also by changing the number of times rubbing in the same direction. It is favorable for the number of times rubbing to be not less than 2 times and not more than 30 times. By rubbing the surface of the copper member with sandpaper, the surface roughness can be controlled. The surface is roughened by rubbing many times and/or increasing the intensity of the rubbing. Also, the surface after the rubbing becomes rougher as the grain size increases.

When plasma processing is performed, it is favorable to use argon (Ar) gas. Specifically, the ceramic copper circuit board 1 is placed inside a processing space; and plasma of Ar gas is generated. The surface is made rougher by exposing the surface of the copper member to the plasma. The plasma processing may be performed at atmospheric pressure, or may be performed at a reduced-pressure atmosphere. It is favorable to use plasma processing because there is also a possibility that elements other than copper that are adhered to the surface of the copper member can be removed.

The surface properties of the copper member may be controlled by etching or chemical polishing. At this time, it is favorable to use a chemical liquid having a controlled dissolution rate of the copper member. The surface of the copper member can be better controlled by using a chemical liquid having a controlled dissolution rate and by controlling the time that the copper member contacts the chemical liquid. It is favorable for the method for controlling the surface properties to be one selected from the methods described above; and two or more methods may be combined.

It is favorable for the holding time of pressure sintering when bonding the semiconductor element to be not less than 100 seconds and not more than 280 seconds. It is more favorable for the holding time to be not less than 120 seconds and not more than 200 seconds. It is favorable for the holding time to be within the ranges described above because fluctuation of the bonding can be reduced. Also, a reducing agent may be added to the bonding layer between the copper member and the semiconductor element. It is favorable for the difference between the average length RSm of the roughness curve elements of the front copper plate 3 and the average length RSm of the roughness curve elements of the back copper plate 4 to be not more than 100 μm.

Examples of the semiconductor element include a Si element, a SiC element, a GaN element, etc. Among these, one of a SiC element or a GaN element is favorable. These semiconductor elements may be elements patterned using a dicer.

(Examples)

Examples of the invention are shown below. First, copper plates were disposed on two surfaces of a ceramic substrate with an active metal brazing material layer interposed. A ceramic copper circuit board was obtained by heating the stacked body to bond the copper plates to the ceramic substrate. The ceramic substrate of the ceramic copper circuit board was a silicon nitride substrate or an aluminum nitride substrate. The thickness of the copper plate was set to be not less than 0.3 mm and not more than 1.0 mm. The thickness of the brazing material layer was set to be not less than 30 μm and not more than 50 μm. The types of the ceramic substrates, the thicknesses of the copper plates, and the thicknesses of the brazing material layers in the examples and the comparative examples were as shown in Table 1.

[Table 1]

|  | Substrate ceramic | Copper plate thickness (mm) | Brazing material layer thickness (μm) |
|---|---|---|---|
| Example 1 | Silicon nitride substrate | 0.8 | 50 |
| Example 2 | Silicon nitride substrate | 1.0 | 40 |
| Example 3 | Silicon nitride substrate | 0.8 | 30 |
| Example 4 | Silicon nitride substrate | 0.6 | 20 |
| Example 5 | Substrate aluminum nitride | 0.6 | 30 |
| Example 6 | Substrate aluminum nitride | 0.3 | 40 |
| Example 7 | Substrate aluminum nitride | 0.3 | 40 |

(continued)

| | Substrate ceramic | Copper plate thickness (mm) | Brazing material layer thickness (μm) |
|---|---|---|---|
| Example 8 | Silicon nitride substrate | 0.8 | 50 |
| Example 9 | Silicon nitride substrate | 1.0 | 40 |
| Example 10 | Silicon nitride substrate | 0.8 | 20 |
| Example 11 | Silicon nitride substrate | 1.2 | 25 |
| Comparative example 1 | Silicon nitride substrate | 0.8 | 50 |
| Comparative example 2 | Silicon nitride substrate | 0.8 | 50 |

For the examples 1 to 11 and the comparative examples 1 to 2, the surfaces of the copper plates of the bonded bodies obtained were processed using sandpaper. The grain size of the sandpaper used for the examples was 20 μm to 50 μm. The surface of the copper plate was roughened by rubbing the surface of the copper plates 2 to 30 times in substantially the same direction. On the other hand, for the comparative example 1, the surface of the copper member was rubbed 10 times using sandpaper having a grain size of not more than 5 μm. For the comparative example 2, the surface of the copper member was rubbed 20 times using sandpaper having a grain size of not less than 100 μm.

The surface roughness of the copper (Cu) member was measured for the examples 1 to 11 and the comparative examples 1 to 2. The results obtained by the surface roughness measurement are shown in Table 2. SURFCOM 2000 DX-23 made by Tokyo Seimitsu Co., Ltd. was used to measure the surface roughness. The surface roughness was measured at five locations selected from the surface of the copper plate. The measurement locations were separated from each other by not less than 500 μm. Also, the values of RSm, Ra, Rv, and Rz were simultaneously measured based on the results of performing the measurements at the five locations. That is, the four parameters of RSm, Ra, Rv, and Rz were simultaneously measured at one measurement location.

Table 2 shows the RSm average value for the five locations, the minimum value among the five RSm, the Ra average value for the five locations, and the Rv average value for the five locations. Also, in the column of the RSm minimum value, the value furthest from 145 μm (the average value of 40 μm and 250 μm, which is the range specified in claim 1) is written in parentheses. In each example, the measurement length was unified at 4.0 mm.

[Table 2]

| | Copper (Cu) member surface roughness parameters | | | |
|---|---|---|---|---|
| | RSm average value (μm) | RSm minimum value (μm) | Ra average value (μm) | Rv average value (μm) |
| Example 1 | 45 | 24 (24) | 0.32 | 0.5 |
| Example 2 | 70 | 52 (52) | 0.46 | 0.9 |
| Example 3 | 100 | 110 (110) | 0.23 | 1.2 |
| Example 4 | 60 | 35 (35) | 0.52 | 1.5 |
| Example 5 | 148 | 125 (125) | 0.60 | 2.0 |
| Example 6 | 245 | 170 (303) | 0.72 | 2.3 |
| Example 7 | 170 | 120 (250) | 0.52 | 2.0 |
| Example 8 | 80 | 70 (70) | 0.32 | 1.3 |
| Example 9 | 200 | 170 (221) | 0.42 | 0.8 |
| Example 10 | 220 | 210 (234) | 0.22 | 1.2 |
| Example 11 | 120 | 85 (85) | 0.12 | 0.6 |
| Comparative example 1 | 35 | 21 (21) | 0.45 | 0.4 |
| Comparative example 2 | 400 | 300 (450) | 1.1 | 5.0 |

It can be seen in Table 2 that the RSm average value for the five locations was within the favorable range for the examples 1 to 11. The RSm minimum value was within the favorable range for the examples 2 to 6, the example 8, and the example 11. On the other hand, the RSm minimum value was outside the favorable range for the example 1, the example 7, the example 9, and the example 10.

The Ra average value for the five locations also was within the favorable range for the examples 1 to 5. The Ra average value was outside the favorable range for the example 6. Furthermore, the Rv average value for the five locations also was within the favorable range for the examples 1 to 5. The Rv average value was outside the favorable range for the example 6. Also, Rz was not more than 10 μm for each measurement location for the examples 1 to 5. On the other hand, in the example 6, there was a location at which Rz was greater than 10 μm.

The silver (Ag) paste was coated onto the surface of the copper plate and dried. As in FIG. 2, a silver (Ag) ribbon was mounted to the copper plate surface of the ceramic copper circuit board thus obtained; and pressure sintering was performed. The bonding strength of the silver (Ag) ribbon was measured by a peel strength test. In the peel strength test, the silver ribbon was pulled perpendicularly to the surface direction of the ceramic substrate; and the strength when the silver ribbon detached from the copper plate was measured. The examples of which the peel strength of the silver ribbon were not less than 4.0 were taken to be "best". The examples of which the peel strength was not less than 3.0 but less than 4 were taken to be "better". The examples of which the peel strength was not less than 2.0 but less than 3.0 were taken to be "good". The examples of which the peel strength was less than 2.0 were taken to be "bad".

The peel strength test was performed using the MX2 series (test speed: 60 mm/min) made by Imada Co., Ltd.; and the electrical signal obtained by this device was converted into a numerical value using a load cell FGP-5 (5 kgf) made by Nidec Shimpo Co. Ltd. The results are shown in Table 3.

[Table 3]

|  | Bonding reliability |
| --- | --- |
| Example 1 | better |
| Example 2 | best |
| Example 3 | best |
| Example 4 | best |
| Example 5 | best |
| Example 6 | good |
| Example 7 | good |
| Example 8 | best |
| Example 9 | good |
| Example 11 | good |
| Example 11 | best |
| Comparative example 1 | bad |
| Comparative example 2 | bad |

It can be seen from Table 3 that the peel strength was not less than 4.0 for each of the examples in which the RSm average value, the Ra average value, and the Rv average value each were within the favorable ranges. On the other hand, for the example 1 of which the RSm minimum value was outside the favorable range, the result of the peel strength test was not less than 3.0 but less than 4.0. For the example 6 of which the Ra average value and the Rv average value were outside the favorable ranges, the results of the peel strength test were not less than 2.0 but less than 3.0. For the comparative examples 1 to 2 of which the RSm average value, the Rv average value, and the RSm minimum value were outside the favorable ranges, the results of the peel strength test were less than 2.0.

It can be seen from the results of Table 2 and the results of Table 3 that the values of the surface roughness (particularly, RSm) greatly affected the peel strength of the bonding with the silver layer.

It is considered that this is due to the following reasons. When the average length RSm of the roughness curve elements is less than 40 μm, the period of the unevenness of the surface of the copper plate is short. The brazing material does not sufficiently penetrate the unevenness of the copper plate surface; and the bonding strength is reduced. On the other hand, when the average length RSm is greater than 250 μm, the period of the unevenness is long, and so a sufficient anchor effect is not provided for the bonding layer contacting the copper plate surface; and the bonding strength is reduced. By setting the average value of the average lengths RSm to be not less than 40 μm and not more than 250 μm, the anchor effect for the bonding layer can be increased, and the bonding strength can be increased.

The control of the surface roughness is particularly useful when the ceramic copper circuit board and the semiconductor element are bonded using silver paste.

Although the bonding layer between the silver ribbon and the copper plate according to the embodiment of the invention is realized and measured using silver paste, the bonding layer is not limited thereto; lead-free solder and/or copper paste may be used. Also, a reducing agent may be added to the paste as necessary. Also, although the peel strength was checked for a copper plate and a bonding layer, anything may be bonded via the bonding layer.

Configuration 1

A ceramic copper circuit board, comprising:

a ceramic substrate; and
a copper member bonded to one surface of the ceramic substrate,
an average value of five average lengths RSm being not less than 40 $\mu$m and not more than 250 $\mu$m, the five average lengths RSm being average lengths RSm of roughness curve elements measured respectively at any five locations selected from a surface of the copper member.

Configuration 2

The ceramic copper circuit board according to claim 1, wherein
the average value of the five average lengths RSm is not less than 60 $\mu$m and not more than 150 $\mu$m.

Configuration 3

The ceramic copper circuit board according to claim 1 or 2, wherein
a minimum value of the five average lengths RSm is not less than 30 $\mu$m.

Configuration 4

The ceramic copper circuit board according to any one of claims 1 to 3, wherein

an average value of five arithmetic average roughnesses Ra is not less than 0.1 $\mu$m and not more than 0.7 $\mu$m, and
the five arithmetic average roughnesses Ra are arithmetic average roughnesses Ra measured respectively at the five locations.

Configuration 5

The ceramic copper circuit board according to any one of claims 1 to 4, wherein

an average value of five maximum valley depths Rv is not less than 0.5 $\mu$m and not more than 2 $\mu$m, and
the five maximum valley depths Rv are maximum valley depths Rv of roughness curves measured respectively at the five locations.

Configuration 6

The ceramic copper circuit board according to any one of claims 1 to 5, further comprising:

a brazing material layer bonding the ceramic substrate and the copper member,
the brazing material layer including at least one selected from silver, copper, and an active metal.

Configuration 7

The ceramic copper circuit board according to any one of claims 1 to 6, wherein
a major component of the ceramic substrate is at least one selected from silicon nitride, aluminum nitride, aluminum oxide, or zirconium oxide.

Configuration 8

The ceramic copper circuit board according to any one of claims 1 to 7, wherein

a thickness of the copper member is not less than 0.6 mm.

Configuration 9

A semiconductor device, comprising:

the ceramic copper circuit board according to any one of claims 1 to 8; and
a semiconductor element mounted to the copper member.

Configuration 10

A semiconductor device, comprising:

the ceramic copper circuit board according to any one of claims 1 to 8;
a semiconductor element mounted to the copper member; and
a bonding layer bonding the semiconductor element to the copper member,
the bonding layer including silver or copper.

According to embodiments of the invention, a ceramic copper circuit board and a semiconductor device are provided in which an average length RSm of roughness curve elements of a surface of a copper member are controlled.
While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

[Reference Numeral List]

1 circuit board
2 ceramic substrate
3 copper member (front copper plate)
4 copper member (back copper plate)
5 brazing material layer (active metal brazing material layer)
6 bonding layer (bonding layer using silver paste or copper paste)
7 silver ribbon
8 semiconductor element
9 semiconductor device

**Claims**

1.  A ceramic copper circuit board (1), comprising:

a ceramic substrate (2); and
a copper member (3) bonded to one surface of the ceramic substrate (2),
an average value of five average lengths RSm being not less than 40 $\mu$m and not more than 250 $\mu$m, the five average lengths RSm being average lengths RSm of roughness curve elements measured respectively at any five locations selected from a surface of the copper member (3).

2.  The ceramic copper circuit board (1) according to claim 1, wherein
the average value of the five average lengths RSm is not less than 60 $\mu$m and not more than 150 $\mu$m.

3.  The ceramic copper circuit board (1) according to claim 1, wherein
a minimum value of the five average lengths RSm is not less than 30 $\mu$m.

4. The ceramic copper circuit board (1) according to claim 1, wherein

an average value of five arithmetic average roughnesses Ra is not less than 0.1 μm and not more than 0.7 μm, and
the five arithmetic average roughnesses Ra are arithmetic average roughnesses Ra measured respectively at the five locations.

5. The ceramic copper circuit board (1) according to claim 1, wherein

an average value of five maximum valley depths Rv is not less than 0.5 μm and not more than 2 μm, and
the five maximum valley depths Rv are maximum valley depths Rv of roughness curves measured respectively at the five locations.

6. The ceramic copper circuit board (1) according to claim 2, wherein
a minimum value of the five average lengths RSm is not less than 30 μm.

7. The ceramic copper circuit board (1) according to claim 2, wherein

an average value of five maximum valley depths Rv is not less than 0.5 μm and not more than 2 μm, and
the five maximum valley depths Rv are maximum valley depths Rv of roughness curves measured respectively at the five locations.

8. The ceramic copper circuit board (1) according to claim 6, wherein

an average value of five maximum valley depths Rv is not less than 0.5 μm and not more than 2 μm, and
the five maximum valley depths Rv are maximum valley depths Rv of roughness curves measured respectively at the five locations.

9. The ceramic copper circuit board (1) according to claim 1, further comprising:

a brazing material layer (5) bonding the ceramic substrate (2) and the copper member (3),
the brazing material layer (5) including at least one selected from silver, copper, and an active metal.

10. The ceramic copper circuit board (1) according to claim 1, wherein
a major component of the ceramic substrate (2) is at least one selected from silicon nitride, aluminum nitride, aluminum oxide, or zirconium oxide.

11. The ceramic copper circuit board (1) according to claim 6, wherein
a major component of the ceramic substrate (2) is at least one selected from silicon nitride, aluminum nitride, aluminum oxide, or zirconium oxide.

12. The ceramic copper circuit board (1) according to claim 1, wherein
a thickness of the copper member (3) is not less than 0.6 mm.

13. A semiconductor device (9), comprising:

the ceramic copper circuit board (1) according to any one of claims 1 to 12; and
a semiconductor element (8) mounted to the copper member (3).

14. A semiconductor device (9), comprising:

the ceramic copper circuit board (1) according to any one of claims 1 to 12;
a semiconductor element (8) mounted to the copper member (3); and
a bonding layer (6) bonding the semiconductor element (8) to the copper member (3),
the bonding layer (6) including silver or copper.

FIG. 1

FIG. 2

FIG. 3

# INTERNATIONAL SEARCH REPORT

| International application No. |
|---|
| **PCT/JP2023/024213** |

### A.    CLASSIFICATION OF SUBJECT MATTER

*H01L 23/13*(2006.01)i; *H01L 23/15*(2006.01)i
FI:    H01L23/12 C; H01L23/14 C

According to International Patent Classification (IPC) or to both national classification and IPC

### B.    FIELDS SEARCHED

Minimum documentation searched (classification system followed by classification symbols)

H01L23/13; H01L23/15

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| A | WO 2018/225809 A1 (DENKA COMPANY LIMITED) 13 December 2018 (2018-12-13) entire text | 1-14 |
| A | WO 2018/180965 A1 (KABUSHIKI KAISHA TOSHIBA) 04 October 2018 (2018-10-04) entire text | 1-14 |
| A | JP 2020-136469 A (NGK SPARK PLUG CO) 31 August 2020 (2020-08-31) entire text | 1-14 |
| P, A | WO 2022/138750 A1 (KABUSHIKI KAISHA TOSHIBA) 30 June 2022 (2022-06-30) entire text | 1-14 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 August 2023** | **29 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/024213**

| Patent document cited in search report | | | Publication date (day/month/year) | Patent family member(s) | | | Publication date (day/month/year) |
|---|---|---|---|---|---|---|---|
| WO | 2018/225809 | A1 | 13 December 2018 | US | 2020/0185320 | A1 | |
| | | | | EP | 3637964 | A1 | |
| | | | | CN | 110731129 | A | |
| | | | | KR | 10-2020-0015519 | A | |
| WO | 2018/180965 | A1 | 04 October 2018 | US | 2019/0327831 | A1 | |
| | | | | EP | 3606299 | A1 | |
| | | | | CN | 110226363 | A | |
| JP | 2020-136469 | A | 31 August 2020 | (Family: none) | | | |
| WO | 2022/138750 | A1 | 30 June 2022 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6262968 B

- JP 2019041108 A